**Europäisches Patentamt**

**European Patent Office**

**Office européen des brevets**

(19)

(11) Veröffentlichungsnummer : **0 439 561 B1**

(12) **EUROPÄISCHE PATENTSCHRIFT**

(45) Veröffentlichungstag der Patentschrift :
**16.02.94 Patentblatt 94/07**

(51) Int. Cl.[5] : **C23C 14/02, C23C 14/42**

(21) Anmeldenummer : **90909697.6**

(22) Anmeldetag : **27.06.90**

(86) Internationale Anmeldenummer :
**PCT/EP90/01032**

(87) Internationale Veröffentlichungsnummer :
**WO 91/00374 10.01.91 Gazette 91/02**

(54) **VERFAHREN UND VORRICHTUNG ZUR BESCHICHTUNG VON SUBSTRATEN.**

(30) Priorität : **27.06.89 EP 89111705**
**19.12.89 DE 3941918**

(43) Veröffentlichungstag der Anmeldung :
**07.08.91 Patentblatt 91/32**

(45) Bekanntmachung des Hinweises auf die
Patenterteilung :
**16.02.94 Patentblatt 94/07**

(84) Benannte Vertragsstaaten :
**AT BE CH DE DK ES FR GB IT LI LU NL SE**

(56) Entgegenhaltungen :
**DD-A- 246 571**
**DE-A- 1 521 262**
**GB-A- 2 155 044**
**J. Vac. Sci. Technol. Volume A5, No. 2,**
**March/April 1987, American Vacuum Society**
**(Woodbury, US) U.K. Chakrabarti et al.:**
**"Deposition of zirconium boride thin films by**
**direct current triode sputtering", pages**
**196-200**
**Le Vide, Les Couches Minces, No. 245, Janu-**
**ary-February 1989 L.A. Stelmack: "Ion-beam**
**assisted deposition of optical coatings", pa-**
**ges 45-58**
**J. Vac. Sci. Technol., Volume A4, No. 6, No-**
**vember/December 1987, American Vacuum**
**Society (Woodbury, US) L.S. Wen et al.: "A**
**transmission electron microscopy study on**
**Ti-N films deposited by ion plating", pages**
**2682-2785**
**Transactions of the Institute of Metal Finis-**
**hing, Volume 64, part 4, November 1986 (Lon-**
**don, GB) B.R. Gardner: "Ion assisted coatings**
**- a new research project at Harwell", pages**
**15-24**

(56) Entgegenhaltungen :
**VEB Deutscher Verlag für Grundstoffindustrie**
**Leipzig, 1979; A. KNAUSCHNER:**
**"Oberflächenveredeln und Plattieren von Me-**
**tallen", Kapitel 5.1.5**
**VDI Verlag Düsseldorf, 1987; H. FREY & G.**
**KIENEL: "Dünnschichttechnologie", Kapitel**
**4.8.1 u. 4.8.3**

(73) Patentinhaber : **HAUZER HOLDING B.V.**
**Groethofstraat 27**
**NL-5900 AE Venlo (NL)**

(72) Erfinder : **Hauzer, Fransiskus**
**Hasselderheidelaan 34**
**NL-5941 CV Velden (NL)**
Erfinder : **Münz, Wolf-Dieter**
**Gerard de Vlamingstraat 9**
**NL-5913 RV Venlo (NL)**
Erfinder : **Veltrop, Hans**
**Burg. Termeerstraat 61**
**NL-5971 VL Grubbenvorst (NL)**
Erfinder : **Wesemeyer, Harald**
**verstorben (DE)**

(74) Vertreter : **Dipl.-Phys.Dr. Manitz**
**Dipl.-Ing.Dipl.-Wirtsch.-Ing. Finsterwald**
**Dipl.-Phys. Rotermund Dipl.-Chem.Dr. Heyn**
**B.Sc.(Phys.) Morgan**
**Postfach 22 16 11**
**D-80506 München (DE)**

Anmerkung : Innerhalb von neun Monaten nach der Bekanntmachung des Hinweises auf die Erteilung des europäischen Patents kann jedermann beim Europäischen Patentamt gegen das erteilte europä-ische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patent-übereinkommen).

Jouve, 18, rue Saint-Denis, 75001 PARIS

## Beschreibung

Die Erfindung betrifft ein Verfahren zur Beschichtung von Substraten, bei dem die aufzubringende Schicht durch auf das betreffende Substrat auftreffende kondensierende Teilchen eines mittels einer Gasentladung erzeugten Plasmas hergestellt und sowohl eine Bodenentladungsverdampfung als auch eine Kathodenzerstäubung vorgenommen wird.

Die Erfindung betrifft ferner eine Vorrichtung zur Durchführung des Verfahrens.

Die Technik der Oberflächenbearbeitung und insbesondere die Herstellung dünner Schichten hat während der vergangenen Jahre auch in ihrer industriellen Anwendung große Bedeutung erlangt. Zu den zahlreichen bekannten Vakuum-Verfahren zur Herstellung von dünnen Schichten bzw. zur Behandlung von Materialoberflächen zählen in erster Linie jene Verfahren, welche auf durch Joule'sche Wärme erzeugter Verdampfung in Öfen, Schiffchen, Tiegeln usw. beruhen und bei denen die Verdampfung insbesondere durch Stromwärme oder durch Elektronenbeschuß mittels eines anodischen oder kathodischen Lichtbogens oder auch eine Wirbelstromerhitzung von leitendem Material in einem induzierten Wechselstromfeld erfolgt. Darüber hinaus ist die großflächige Zerstäubung von Kathoden in den verschiedenen Ausführungsformen der Kathodenzerstäubung mit oder ohne magnetische Verstärkung der Ionisation in der Gleichstrom- oder Wechselstromglimmentladung bekannt.

Aus der DD-A-246 571 ist ein Verfahren der eingangs genannten Art bekannt, bei dem als einziges Plasmaerzeugungssystem ein Bogenentladungsverdampfer verwendet wird. Die Beschichtungseinrichtung zur Durchführung dieses Verfahrens ist zusätzlich mit wenigstens einer Sputter-Einrichtung ausgestattet, die aus einem potentialvariablen Target und einer Targetabschirmung besteht. Das mittels dieser Vorrichtung durchgeführte Verfahren umfaßt die folgenden Verfahrensschritte:

Nachdem die Substratoberfläche bei geringer Verdampfung durch Ionenbeschuß abgestäubt ist, beginnt der eigentliche Beschichtungsvorgang. Hierbei wird das Grundmaterial der aufzubringenden Mischschicht in der Bogenentladung verdampft und Legierungs- bzw. Dotierungsmaterial gesputtert. Durch ein gegenüber dem Substratpotential negatives Potential des Targets wird erreicht, daß aus dem Plasma der Bogenentladungsverdampfung Ionen mit entsprechender Energie extrahiert werden, die die Ionenzerstäubung des Targets bewirken. Der Dampf aus dem Bogenentladungsverdampfer vermischt sich mit dem zerstäubten Material des Targets, wodurch sich eine Mischschicht auf dem Substrat ausbildet.

Aus der Druckschrift A. Knauschner "Oberflächenveredeln und Plattieren von Metallen", VEB Deutscher Verlag für Grundstoffindustrie Leipzig, 1979, ist es bekannt, daß beim Ionenplattieren der gleichzeitige Ablauf von Bedampfung, Zerstäubung und energetischer Anregung zu gleichmäßigen und dichten Aufdampfstrukturen, zur Erhöhung der Haftfestigkeit, zur Verringerung der Porösität und zur Erhöhung der Korrosionsbeständigkeit führen kann. Außerdem ist in dieser Druckschrift auf die Möglichkeit eines alternierenden Ionenplattierens verwiesen. Hierbei wird die Schicht durch laufend wechselnde Einwirkung von Ionen und Dampfteilchen aufgebaut, so daß erreicht wird, daß konventionelle Verdampfer und Ionenquellen eingesetzt werden können. Eine Verbesserung der Beschichtungsqualität ist durch das alternierende Beaufschlagen des Substrats mit einem Ionenstrom und einem Dampfstrom nicht zu erreichen.

Auch in der Druckschrift H. Frey und G. Kienel: "Dünnschichttechnologie", VDI-Verlag Düsseldorf, 1987, Seiten 133 bis 139, wird erwähnt, daß sich Ionenplattiereffekte auch dann erzielen lassen, wenn jede Substratstelle alternierend dem Dampfstrom und dem Ionenstrom ausgesetzt wird. Es werden in dieser Druckschrift auch die verwendbaren Vorrichtungen zur Erzeugung des Dampfstromes und zur Ionenerzeugung erwähnt, und es wird dabei darauf hingewiesen, daß man den Dampfstrom durch eine von der Ionisierungsquelle getrennte Energiequelle erzeugen kann, jedoch für das Ionenplattieren solche Verfahren besondere Bedeutung haben, bei denen durch eine einzige Energiequelle sehr wohl die Partikel verdampft als auch teilweise ionisiert werden.

Bei den bekannten und gebräuchlichen ionenunterstützten Verdampfungsverfahren sind die kinetischen Energien der auf das Substrat auftreffenden Atome und Ionen bzw. die auf dem Substrat auftreffenden Teilchen derart verteilt, daß die hochenergetischen Teilchen Defekte im Kristallgitter der kondensierenden Schicht bewirken, die zu Druckspannungen und zur Versprödung der Schicht führen, bzw. Effekte auslösen, die zu einer unerwünschten Rückzerstäubung oder Wiederzerstäubung der kondensierenden Schicht führen.

Andererseits erreichen die auftreffenden Teilchen niedriger Energie oft kaum die notwendige Bewegungsenergie an der Oberfläche, um einen homogenen Schichtaufbau zu gewährleisten.

Eine besonders breite und daher ungünstige Verteilung der Bewegungsenergien der auf dem Substrat auftreffenden Atome und Ionen liegt insbesondere beim Bogenverdampfer vor. Außerdem treten bei den verschiedensten Formen des Bogenverdampfers häufig als Droplets bezeichnete Makropartikel auf, die besonders dann störend wirken, wenn eine korrosionsbeständige Werkstoffbeschichtung gefordert wird oder wenn der Reibungskoeffizient des Schichtmaterials besonders niedrig sein soll.

2

Bei der Kathodenzerstäubung wirkt sich im Vergleich zur Bogenverdampfung die geringe Konzentration ionisierter Teilchen vor allem in der direkten Umgebung der zu beschichtenden Substrate ungünstig aus, was sehr häufig dazu führt, daß die kondensierenden Schichten, vor allem bei der Abscheidung von Schichten mit hohem Schmelzpunkt, wie es z. B. bei der Hartstoffbeschichtung der Fall ist, nicht genügend dicht sind.

Außerdem hat sich gezeigt, daß mittels Kathodenzerstäubung abgeschiedene Schichten denjenigen Schichten, die mittels Bogenverdampfung abgeschieden wurden, hinsichtlich Haftfestigkeit unterlegen sind.

Andererseits ist es bei der Kathodenzerstäubung möglich, durch geeignete Wahl einer negativen Substratvorspannung die kinetische Energie der auftreffenden ionisierten Teilchen im Bereich von einigen wenigen Eletronenvolt, beispielsweise 10 eV, bis hin zu 1000 eV und mehr exakt einzustellen, während die Mehrzahl der nicht ionisierten Atome eine kinetische Energie von typischerweise kleiner 10 eV aufweisen.

Aufgabe der Erfindung ist es, ein Verfahren zu entwickeln, das einerseits die Abscheidung möglichst defektfreier und gleichzeitig gut haftender, d. h. qualitativ hochwertiger Schichten gewährleistet, und andererseits ausreichende Möglichkeiten bietet, durch geeignete Wahl der Abscheidungsparameter das Schichtwachstum den geforderten Gegebenheiten optimal und exakt anzupassen.

Diese Aufgabe wird gemäß der Erfindung durch ein Verfahren und eine Vorrichtung gemäß den Ansprüchen 1 und 18 dadurch gelöst, daß die Bogenentladungsverdampfung nur während einer ersten Beschichtungsphase und die Kathodenzerstäubung während einer auf diese erste Phase folgenden zweiten Beschichtungsphase durchgeführt wird. Weitere Vorteilhafte Ausführungsformen sind in den abhängigen Ansprüchen 2-17 und 19 definiert.

Aufgrund der der Kathodenzerstäubung vorangehenden Bogenentladungsverdampfung wird mit hochenergetischen Ionen eine übergangsschicht auf der Substratoberfläche erzeugt, welche eine gute Haftung der aufzubringenden Schicht auf dem Substrat gewährleistet, während bei der anschließenden Kathodenzerstäubung sowohl die Kondensationsgeschwindigkeit bei geringer Teilchenenergie in weiten Bereichen entsprechend dem gewünschten Kristallwachstum und dem gewünschten Kristallgefüge der aufzubringenden Schicht als auch die Vorspannung am Substrat feinfühlig steuerbar ist. Aufgrund der geringen freien Weglänge der Bedampfungsteilchen erfolgt teilweise auch um die Ecken herum eine gleichmäßige Schichtdickenverteilung.

Die Kathodenzerstäubung kann dann so geführt werden, daß der Dampf des Kathodenmaterials sowie die an der Kathodenzerstäubung teilnehmenden Gasatome im Raum zwischen Kathode und Substrat bzw. Substraten mit Hilfe von gegenüber herkömmlicher, bekannter Methoden der Kathodenzerstäubung, wie z.B. Gleichspannungszerstäubung oder Magnetronzerstäubung, zusätzlich vorgesehener Magnetfelder wesentlich höher ionisiert werden kann, wodurch eine dichte Schichtabscheidung ermöglicht wird. Erreicht wird dies durch Streufelder speziell angebrachter, insbesondere aus Spulen bestehender Magnetanordnungen, die nach den bekannten Prinzipien der magnetfeldunterstützten Zerstäubung und des unbalancierten Magnetrons ausgebildet sein können (siehe Literatur 1, 2, 3, 4, 5, 6).

Da bei der Bogenentladungsverdampfung der Großteil der auf dem Substrat kondensierenden Teilchen ionisiert ist, läßt sich die kinetische Energie beispielsweise mittels einer negativen Vorspannung am Substrat vorteilhaft und problemlos steuern. Mit der erfindungsgemäßen Kombination von Bogenentladungsverdampfung und Kathodenzerstäubung, insbesondere der Kathodenzerstäubung mittels eines unbalancierten Magnetrons, werden die durch die erzielbare gute Haftfestigkeit sowie die erzielbare hohe Schichtqualität bestimmten Vorteile beider Beschichtungsverfahren in optimaler Weise ausgenutzt, ohne die eingangs erwähnten Nachteile der Einzelverfahren in Kauf nehmen zu müssen.

Vorzugsweise wird das Substrat während der Bogenentladungsverdampfung zunächst mit Ti-Ionen derart optimierter Energie und entsprechender Ionenstromdichte beschossen, daß die Substratoberfläche durch Ionenätzen gereinigt, d.h. in bekannter Weise teilweise abgetragen wird. Die für diese Oberflächenreinigung erforderliche hohe Ionenenergie läßt sich z.B. durch Anlegen einer negativen Substratvorspannung im Bereich von 1500 V bis 2000 V leicht erzeugen.

Anschließend wird ebenfalls mit Hilfe der Bogenentladungsverdampfung die für die erfindungsgemäße Kombination von Bogenentladungsverdampfung und Kathodenzerstäubung wichtige übergangszone im unmittelbaren Bereich unterhalb der Substratoberfläche gebildet. Dazu wird die Tatsache genutzt, daß die z.B. bei der Bogenentladungsverdampfung erzeugten, mehrfach ionisierten Ti-Atome unter bestimmten Bedingungen in die Substratoberfläche implantiert werden. Dazu muß die Energie der Ti-Ionen einerseits genügend hoch, andererseits aber nicht zu hoch sein, um zu vermeiden, daß der vorstehend beschriebene Ätzvorgang ausgelöst wird.

Dies kann z. B. bei Substraten aus verschiedenen legierten Stählen dann erreicht werden, wenn die negative Substratspannung im Bereich zwischen 1000 und 1500 V, vorzugsweise zwischen 1100 und 1200 V liegt.

Im Falle von eisenhaltigen Substraten bilden sich dann beispielsweise Ti-Fe-Mischkristalle, die eine besonders vorteilhafte Verankerung einer z.B. bei der Beschichtung aufwachsenden TiN-Schicht gewährleisten. Ähnlich günstige Ergebnisse lassen sich erzielen, wenn man anstatt von Ti-Ionen Zr-, Hf-, Cr-, Ta-, Nb- oder V-Ionen zur Vorbehandlung benutzt. In diesen Fällen bildet sich direkt unterhalb der Substratoberfläche zunächst eine etwa 200-400 Angström dicke, mischkristallreiche Zone, während sich darunter noch ein Diffusionsprofil der implantierten Fremd-Ionen einstellt, das sich bis 1500 bis 2000 Angström tief in den Substratbreite erstreckt.

Diese Übergangsschicht bewirkt dann, wenn die Ionenenergie, z.B. des Ti-Dampfes, entsprechend optimiert ist, während einer mechanischen Belastung eine Stützfunktion der z.B. sehr harten und relativ spröden TiN-Beschichtung.

Die Fortführung des Beschichtungsprozesses kann nach zweierlei Methoden durchgeführt werden:

Einerseits kann unter Beibehaltung der Bogenentladungsverdampfung die negative Vorspannung am Substrat so weit reduziert werden, daß die am Substrat ankommenden Metallatome und Metallionen in Gegenwart von Stickstoffatomen und Ionen mehrheitlich kondensieren. Dies ist z.B. der Fall, wenn die negative Substratvorspannung im Bereich von 10 bis 200 V, vorzugsweise zwischen 50 und 100 V liegt. Die Beschichtung wird unterbrochen, wenn z.B. bis zu 20 % der gewünschten Schichtdicke von beispielsweise TiN erreicht ist. Dann wird der Prozeß umgeschaltet und auf Kathodenzerstäubung eingestellt.

Zum anderen läßt sich eine noch bessere Gestaltung des Übergangs vom Substrat zur Schicht bewerkstelligen, wenn man direkt nach Herstellung der Übergangsschicht mittels Bogenentladungsverdampfung die Ionenimplantation direkt auf die Beschichtung mittels Kathodenzerstäubung und hier vornehmlich unter Verwendung eines unbalancierten Magnetrons umschaltet. Im Falle der Abscheidung von z.B. TiN ist es vorteilhaft, bei der Kathodenzerstäubung eine negative Substratvorspannung im Bereich von 40 V bis 200 V, vorzugsweise jedoch von 50 +/- 25 V anzulegen. Es ist dabei darauf zu achten, daß der Ionenbeschuß mit einer Ionenstromdichte größer 2 mA/cm$^2$ durchgeführt wird, um eine ausreichende Schichtdicke zu erreichen (siehe Literatur 7, 8).

Der Prozeß der Bogenentladungsverdampfung und der Kathodenzerstäubung kann von ein und derselben Kathode aus durchgeführt werden. Es ist jedoch auch möglich, für beide Prozeßschritte eine getrennte bzw. eine eigene Kathode zu benutzen. Dies führt einerseits zu einer Verteuerung des Anlagenkonzepts, eröffnet aber andererseits auch die Möglichkeit, die Ausbildung der Übergangsschicht mit von der eigentlichen Beschichtung unterschiedlichen Materialien durchzuführen.

Eine Vorrichtung zur Durchführung des Verfahrens nach der Erfindung umfaßt eine das jeweilige Arbeitsgas aufnehmende Kammer, einen in der Kammer angeordneten Substrathalter sowie verschiedene elektrische Stromkreise, die zur Durchführung der verschiedenen Verfahrensschritte erforderlich sind. Die verwendete Kammer ist dabei so konstruiert, daß sie mit herkömmlichen Vakuumpumpständen auf 10$^{-5}$ mbar ausgepumpt werden kann. Die Kammer ist dabei elektrisch geerdet.

Die Erfindung wird nachfolgend anhand der Zeichnung näher erläutert; in der Zeichnung zeigt:

Fig. 1 ein Diagramm der typischen Verteilung der kinetischen Energien der beim Beschichten eines Substrats mittels einer herkömmlichen Bogenentladungsverdampfung auf das Substrat auftreffenden Teilchen,

Fig. 2 Prinzipschaltbilder zur Erläuterung der Bogenentladungsverdampfung und der Kathodenzerstäubung,

Fig. 3 eine schematische Darstellung einer Vorrichtung zur Durchführung des Verfahrens nach der Erfindung,

Fig. 4 eine schematische Darstellung einer Magnetronkathode,

Fig. 5 eine Querschnittsdarstellung einer Multikathodenanlage,

Fig. 6 eine schematische Querschnittdarstellung eines unbalancierten Magnetrons,

Fig. 7 und 8 ein Beispiel eines Schichtaufbaus und der zugehörigen Prozeßschritte in schematischer Darstellung, und die

Fig. 9 und 10 eine schematische Darstellung einer bevorzugten Schichtfolge und den zeitlichen Ablauf der zugehörigen Prozeßschritte.

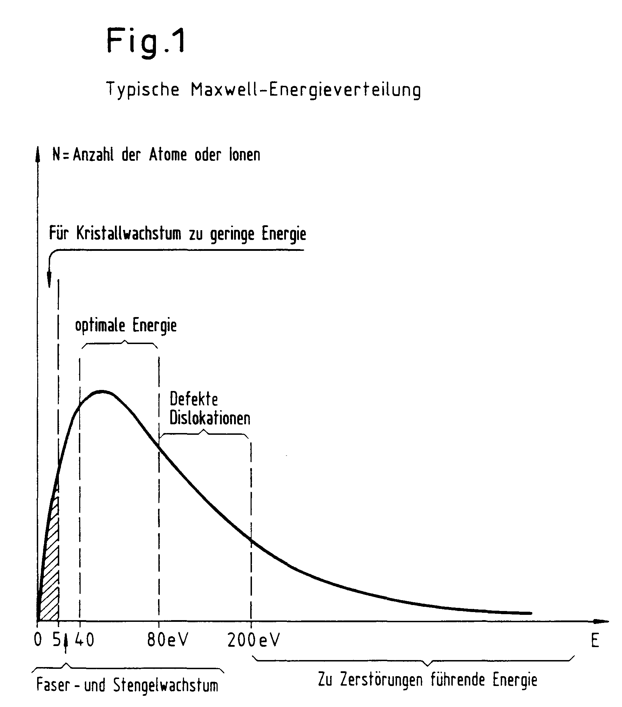

Das Diagramm gemäß Fig. 1 zeigt die typische Verteilung der kinetischen Energien der auf ein zu beschichtendes Substrat auftreffenden Teilchen, wie sie sich bei einer Beschichtung mittels einer herkömmlichen Bogenentladungsverdampfung ergibt. Hierbei ist auf der Abszisse die kinetische Energie und auf der Ordinate die jeweilige Häufigkeit der auftreffenden, kondensierenden Teilchen aufgetragen.

Wie sich aus diesem Diagramm ergibt, liegt der ideale Energiebereich erfahrungsgemäß bei etwa 40 bis 80 eV. Geringere oder größere Energien führen zu Defektmechanismen, die im Diagramm angegeben sind.

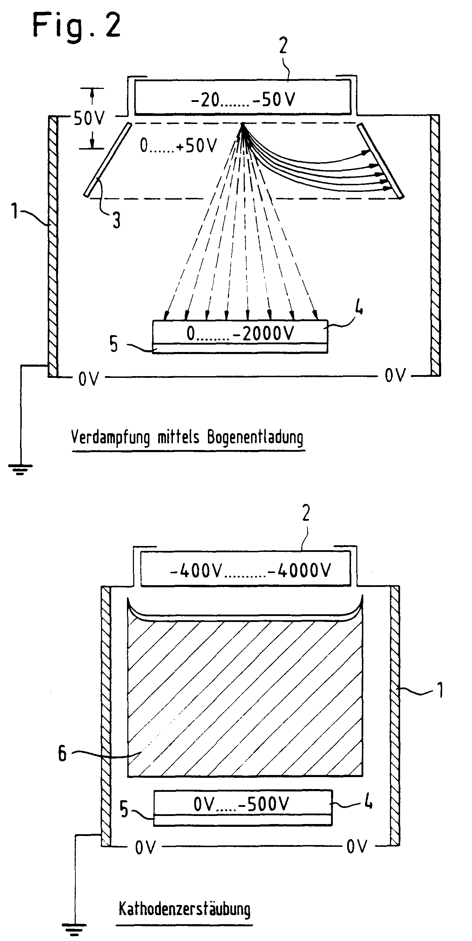

In Fig. 2 sind Prinzipschaltbilder der Bogenentladungsverdampfung und der Kathodenzerstäubung gezeigt.

Im Behälter 1 ist eine Kathode 2 angeordnet.

Im Falle der Bogenentladungsverdampfung liegt diese Kathode auf einem Potential von -20 V bis -50 V. Der Bogenstrom bildet sich zwischen Kathode 2 und Anode 3 aus.

Die Anode liegt auf einem typischen Potential im Bereich zwischen 0 und +50 V. Der Bogenstrom kann dabei bis zu mehreren 100 A betragen. Ein Teil des Stromes breitet sich in den Raum in Richtung von Substraten 4 aus. Diese Substrate liegen je nach Bedarf im Falle des Ätzprozesses auf einer negativen Vorspannung bis zu 2000 V, und im Falle der Ausbildung der Übergangsschicht beispielsweise zwischen 1100 und 1200 V oder während der Beschichtung bei ca. 100 V.

Die Substrate sind mit dem Substrathalter 5 fest verbunden, und letzterer ist elektrisch isoliert in der Kammer 1 eingebaut und kann mit einer geeigneten Stromversorgung verbunden werden.

Im Falle der konventionellen Kathodenzerstäubung liegt die negative Vorspannung bei 3000 bis 4000 V. Typische Werte für die Magnetronzerstäubung liegen zwischen 400 und 700 V. Das raumerfüllende Plasma der konventionellen Kathodenzerstäubung ist mit dem Bezugszeichen 6 schematisch angedeutet. Für die Substrate 4 und den Substrathalter 5 gelten die gleichen Bedingungen wie im Falle der Bogenentladungsverdampfung.

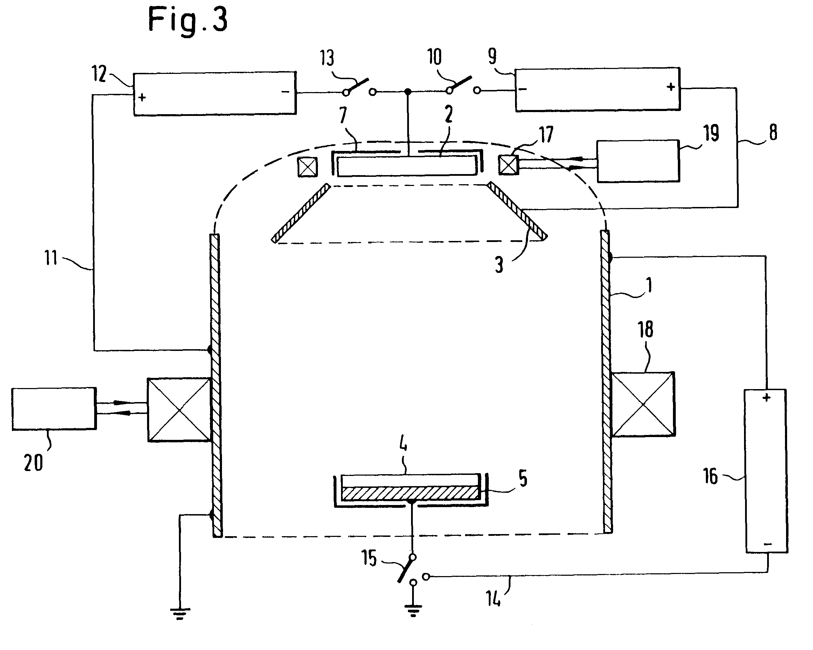

Fig. 3 zeigt ein Blockdiagramm eines Beispiels einer Vorrichtung zur Durchführung des Verfahrens nach der Erfindung. Dabei wird von einer gemeinsamen Kathode 2 für die Bogenentladungsverdampfung und für die Kathodenzerstäubung ausgegangen.

Die Kathode 2 ist von einer auf Erdpotential oder schwebend liegenden Dunkelfeldabschirmung oder von Isolationsmaterial 7 umgeben. Kathode 2 und Anode 3 sind im Stromkreis 8 miteinander verbunden. In diesem Stromkreis liegt die Stromversorgung 9 für die Aufrechterhaltung der Bogenentladung bzw. der Schalter 10 zur wahlweisen Betätigung der Bogenentladungsverdampfung.

Parallel zum Stromkreis 8 liegt der Stromkreis 11, der die Stromversorgung 12 über den Schalter 13 zur wahlweisen Aufrechterhaltung der Kathodenzerstäubungsentladung mit der Kathode 2 verbindet. Der positive Ausgang der Stromversorgung 12 liegt in bekannter Weise auf Erdpotential. Schließlich verbindet ein Stromkreis 14 den Substrathalter 5 über einen Schalter 15 mit dem negativen Ausgang der Stromversorgung 16. Der positive Ausgang liegt in diesem Falle wieder auf Erd- bzw. Kammerpotential.

Mit den Bezugszeichen 17 und 18 sind zwei mögliche Ausführungsformen von Magnetisierungseinrichtungen für das Plasma (Bezugszeichen 6 in Fig. 2) angedeutet. Je nach technischer Realisation werden diese aus Streufeldspulen bestehenden Magnetisierungseinrichtungen 17 bzw. 18 mit den Gleichspannungsversorgungen 19 bzw. 20 elektrisch verbunden. Die Höhe des Spulenstromes ist dabei so einzustellen, daß die Ionenstromdichte an den Substraten 4 unter der Wirkung der von der Stromversorgung 16 stammenden negativen Vorspannung über 2 mA/cm$^2$ liegt.

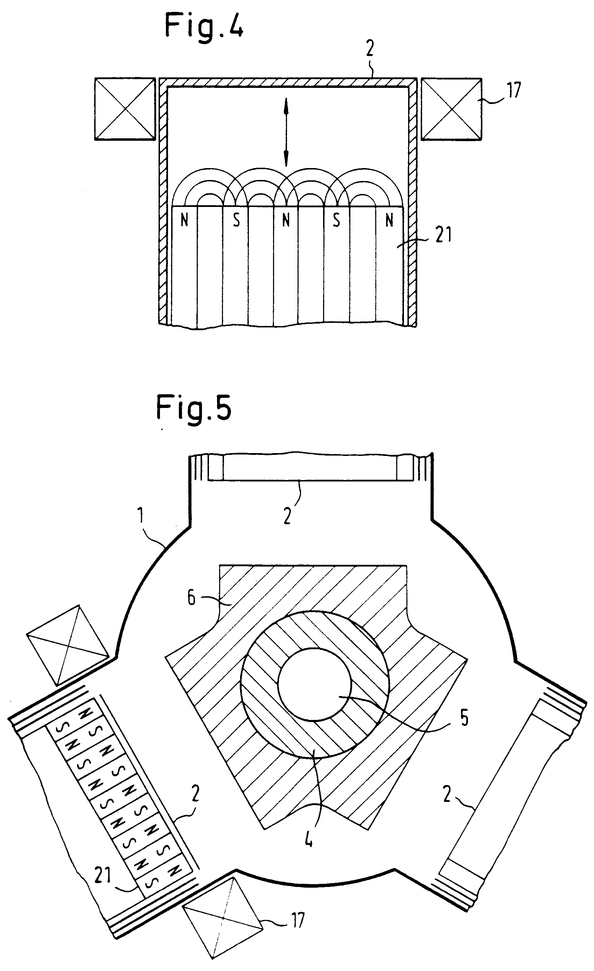

Fig. 4 zeigt eine an sich bekannte Ausführungsform einer Magnetronkathode. Das Bezugszeichen 2 bezeichnet dabei das Target einer konventionellen oder Magnetronkathode. Mit dem Bezugszeichen 21 wird eine spezielle Magnetanordnung bezeichnet. Eine Streufeldspule 17, wie sie auch schon in Fig. 3 gezeigt ist, umschließt die Anordnung im Bereich des Targets 2. Der eingezeichnete Doppelpfeil verdeutlicht, daß das Magnetfeld bezüglich des Targets 2 verschiebbar ist. Dies ist deshalb von praktischer Bedeutung, weil es von Vorteil ist, die Bogenentladungsverdampfung wahlweise mit oder ohne Einfluß des Magnetfeldes vonstatten gehen zu lassen, während bei der Kathodenzerstäubung das Magnetfeld für den Magnetronbetrieb der Kathode von Bedeutung ist.

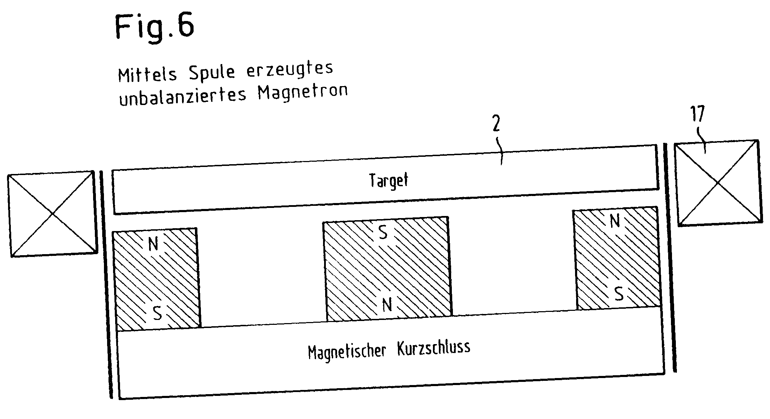

Fig. 5 zeigt einen Querschnitt einer Multikathodenanlage. Dabei befinden sich in der Kammer 1 zwei konventionelle Kathoden und eine Magnetronkathode. Eine der konventionellen Kathoden kann in diesem Falle als Bogenentladungsverdampfer verwendet werden, während die andere als Zerstäuberquelle dient. Schließlich zeigt Fig. 6 die in der einschlägigen Fachliteratur am häufigsten dargestellte Form eines Magnetrons im Querschnitt. Dabei dient die Spule 17 wieder zur Erhöhung der Ionisation des Raumes und wirkt in Verbindung mit der Magnetanordnung aus Permanentmagneten, vorzugsweise aus SmCo oder NdFeB, als unbalanciertes Magnetron.

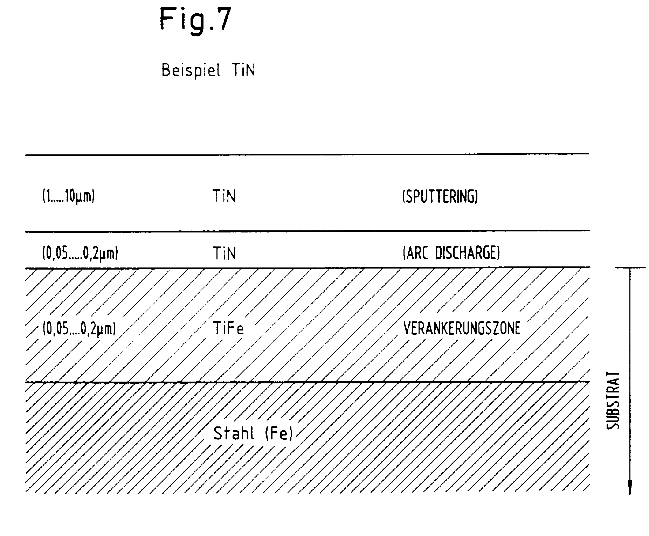

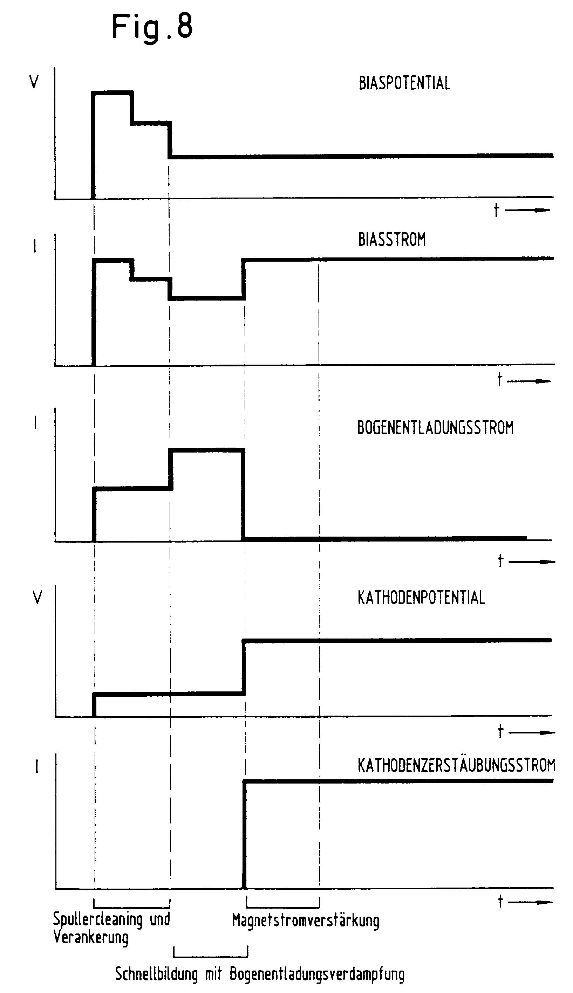

Die Fig. 7 und 8 geben den Schichtaufbau und die einzelnen Prozeßschritte im Schema wieder.

Fig. 7 zeigt in typischer Weise ein Substrat aus Stahl, dessen Oberfläche durch die quasi als "Verankerungszone" wirkende Übergangsschicht gekennzeichnet ist. Im Falle der Verwendung von Ti als Beschichtungsmaterial bilden sich in diesem Bereich intermetallische Phasen, bestehend aus TiFe, aus. Auf dieser Übergangszone liegt dann ein erster Schichtanteil aus TiN, der durch das reaktive Aufdampfen mittels Bogenentladungsverdampfung entsteht. Es folgt die TiN-Schicht, die mit Hilfe der Kathodenzerstäubung abgeschieden wurde.

Fig. 8 zeigt den zeitlichen Ablauf der charakteristischen elektrischen Verfahrensparameter in schematischer Darstellung.

Während des Ätzvorganges ist die Biasspannung an den Substraten am höchsten (typisch -1600 V) und wird schrittweise bei der Bildung der Übergangszone (typisch -1100 V) und bei der Beschichtung mit Hilfe der Stromversorgung 16 abgebaut. Der Strom an den Substraten ist zunächst sehr hoch und wird während der Bildung der Übergangsschicht verkleinert.

Bei der Beschichtung mittels Bogenentladungsverdampfung wie auch während der Phase der Kathodenzerstäubung kann die negative Substratvorspannung auf konstantem Niveau gehalten werden, nämlich typischerweise auf 50 V ± 25 V.

Zur Erzielung eines ausreichenden Ionenstroms am Substrat wird der Bogenstrom (Stromversorgung 9) erhöht.

Das Kathodenpotential ist während der ersten Prozeßschritte mittels Stromversorgung 9 nahezu konstant (typisch -20 V) und wird z.B. bei Verwendung von Magnetronkathoden während der Beschichtung durch Kathodenzerstäubung auf typisch -500 V mittels Stromversorgung 12 erhöht bzw. eingestellt.

Der Kathodenstrom während der Kathodenzerstäubung ist stromgeregelt (Stromversorgung 12) und bleibt im Verlauf des weiteren Beschichtungsprozesses konstant.

Der Ionenstrom zu den Substraten (Biasstrom) ist bei Verwendung der magnetischen Zusatzionisierung, z.B. mittels Magnetisierungseinrichtungen 17, 18, entsprechend hoch und liegt über 2 mA/cm$^2$.

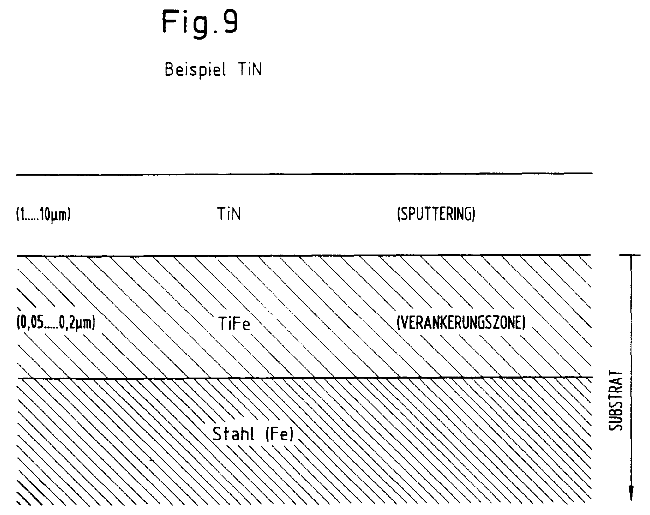

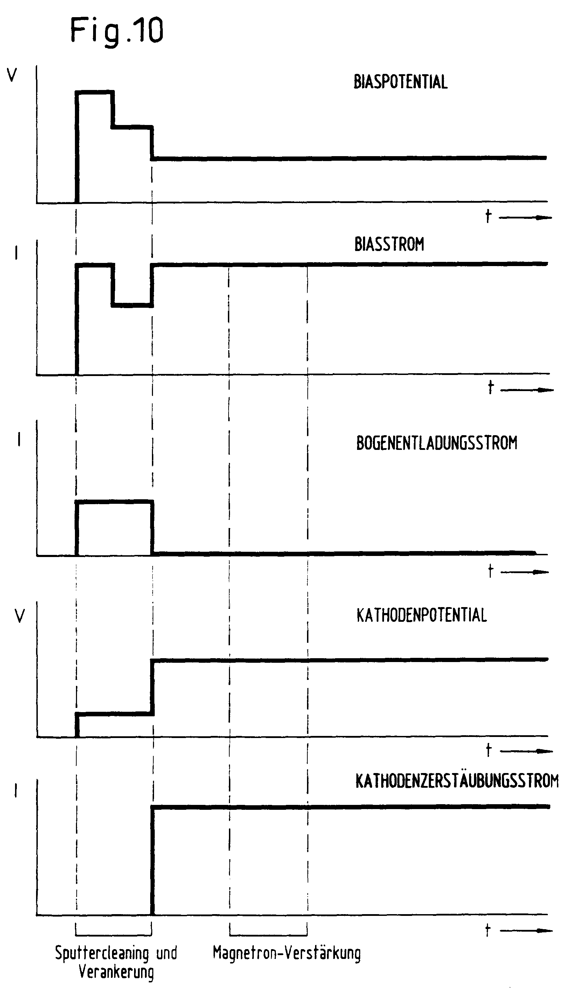

Die Fig. 9 und 10 stellen die bevorzugte Art des Verfahrens am Beispiel der TiN-Beschichtung dar.

Dabei zeigt Fig. 9 wieder die Schichtfolge. Über der "Verankerungszone" liegt direkt die TiN-Schicht.

Die Fig. 10 gibt den zeitlichen Ablauf der Prozeßschritte wieder.

Im Vergleich zu Fig. 8 fehlt die Phase der Bogenentladungsbedampfung zur Herstellung einer ersten TiN-Schicht.

Die wichtigsten Prozeßparameter für das Verfahren nach der Erfindung sind unter besonderer Berücksichtigung der Ansprüche 10, 12, 14, 15, 16 in der nachfolgenden Tabelle zusammengestellt:

Tabelle: Prozeßparameter

| Prozeßschritt | Prozeßparameter | Einheit | Funktionsbereich | | Bevorzugter Bereich | |
|---|---|---|---|---|---|---|
| Ätzen | Bogenspannung | V | 15 – | 50 | 20 – | 40 |
| | Bogenstrom | A | 40 – | 400 | 50 – | 250 |
| | Druck | $10^{-5}$ mbar | 0,1 – | 2 | 0,5 – | 1 |
| | Neg. Substrat Bias | V | 1300 – | 2000 | 1500 – | 1600 |
| | Ätzzeit | min | 1 – | 10 | 2 – | 5 |
| Übergangszone (Ionenimplantation) | Bogenspannung | V | 15 – | 50 | 20 – | 40 |
| | Bogenstrom | A | 40 – | 400 | 50 – | 250 |
| | Druck | $10^{-5}$ mbar | 0,1 – | 2 | 0,5 – | 1 |
| | Neg. Substrat Bias | V | 1000 – | 1500 | 1000 – | 1200 |
| | Implant. Zeit | min | 1 – | 20 | 5 – | 10 |
| Beschichtung (unbalanciertes Magnetron) | Entladungs-Spannung | V | 300 – | 750 | 500 – | 600 |
| | Entladungs-Leistung | $W/cm^2$ | 5 – | 30 | 10 – | 15 |
| | Totaldruck | $10^{-3}$ mbar | 0,5 – | 50 | 1 – | 3 |
| | Neg. Substrat Bias | V | 0 – | 500 | 50 $\pm$ | 25 |
| | Biasstromdicke | $mA/cm^2$ | 1 – | 10 | 2 – | 4 |
| | Rate | nm/sec | 0,5 – | 10 | 1 – | 1,5 |
| | Schichtdicke | µm | 1 – | 10 | 3 – | 5 |
| | Substrattemperatur | °C | 250 – | 600 | 350 – | 450 |

EP 0 439 561 B1

Literatur:

1. L. Maissel, "Handbook Thin Film Technology"
Mc Grawhill Book Company, 1970, Seite 4.8
2. T. Hata, R. Noda, O. Morimoto, T. Hada
Appl. Phys. Lett., 37 (3) 1980, 633
3. B. Window, F. Sharples, N. Savvides,
Vac. Sci. Technol., A 3 (6) 1985, 2368
4. B. Window, N. Savvides
Vac. Sci. Technol., A 4 (2) 1986, 196
5. B. Window, N. Savvides
Vac. Sci. Technol., A 4 (3) 1986, 453
6. S. Kadlec, V. Musil, W.-D. Münz, G. Hakansson
E. Sundgren, 16th ICMC, San Diego, USA, 1989 (im Druck)
7. H. Freller, H.P. Lorenz
Vac. Sci. Techn., A 4 (1986), 2691
8. H. Freller
Proc. SURTEC, Berlin '89, Carl Hanser Verlag, München, 133

## Patentansprüche

1.  Verfahren zur Beschichtung von Substraten, bei dem die aufzubringende Schicht durch auf das betreffende Substrat auftreffende kondensierende Teilchen eines mittels einer Gasentladung erzeugten Plasmas hergestellt und sowohl eine Bogenentladungsverdampfung als auch eine Kathodenzerstäubung vorgenommen wird,
    dadurch **gekennzeichnet,**
    daß die Bogenentladungsverdampfung nur während einer ersten Beschichtungsphase und die Kathodenzerstäubung während einer auf diese erste Phase folgenden zweiten Beschichtungsphase durchgeführt wird.

2.  Verfahren nach Anspruch 1,
    dadurch **gekennzeichnet,**
    daß das Substrat während der Bogenentladungsverdampfung mit Ionen beschossen und dabei die Energie und Ionenstromdichte derart gewählt werden, daß die Substratoberfläche durch Ionenätzung gereinigt und teilweise abgetragen wird.

3.  Verfahren nach Anspruch 2,
    dadurch **gekennzeichnet,**
    daß der Beschuß mittels Ionen aus Inertgas oder von der Kathode stammenden Metallionen oder aus einem Gemenge derselben erfolgt.

4.  Verfahren nach Anspruch 1,
    dadurch **gekennzeichnet,**
    daß bei dem während der Bogenentladungsverdampfung erfolgenden Beschuß des Substrats mit Ionen die Ionenenergie und Ionenstromdichte derart gewählt werden, daß eine Verankerung der aufzubauenden Schicht im Substratmaterial bewirkt wird.

5.  Verfahren nach Anspruch 4,
    dadurch **gekennzeichnet,**
    daß der Beschuß des Substrats mit Metallionen erfolgt.

6.  Verfahren nach einem der vorhergehenden Ansprüche,
    dadurch **gekennzeichnet,**
    daß der Ionenbeschuß des Substrates mit derart gewählte Ionenenergie und Ionenstromdichte durchgeführt wird, daß eine Ionenimplantation, insbesondere eine Implantation von Metallionen, stattfindet, bei der die Ionen bis einige Atomnetzebenen tief in das Substrat eindringen und zur Verankerung der aufzubauenden Schicht infolge örtlicher Erwärmung eine Interdiffusion von Atomen in den Substrat-Kristallgittern angeregt wird, welche feste Lösungen der eindringenden Atome in den Kristalliten, eine Mischkristallisation und beispielsweise bei Metallen auch intermetallische Verbindungen bewirkt.

7. Verfahren nach Anspruch 6,
dadurch **gekennzeichnet,**
daß zur Bildung der Verankerung Titanionen benutzt werden, und daß während des Ätzvorganges an der Oberfläche des Substrates direkt unterhalb der Oberfläche eine intermetallische Schicht, zum Beispiel FeTi in einer Dicke von 10 bis 100 nm, insbesondere 20 bis 40 nm, oder mit anderen schwer schmelzbaren Metallen wie beispielsweise Zirkon oder Hafnium gebildet wird.

8. Verfahren nach einem der vorhergehenden Ansprüche,
dadurch **gekennzeichnet,**
daß die während der Bogenentladung eingestellten Parameter zu einer Schichtabscheidung, zum Beispiel von TiN, führen (Schicht I), und daß diese Beschichtung unterbrochen und durch Kathoden- oder Magnetronzerstäubung bis zur gewünschten Schichtdicke (Schicht II) fortgesetzt wird.

9. Verfahren nach Anspruch 8,
dadurch **gekennzeichnet,**
daß der durch Bogenentladung hergestellte Schichtanteil bis zu etwa 20 % der von Schicht I und Schicht II gebildeten Gesamtschichtdicke beträgt.

10. Verfahren nach einem der vorhergehenden Ansprüche,
dadurch **gekennzeichnet,**
daß unmittelbar nach der Ausbildung der Verankerung TiN direkt mittels der Kathoden- oder Magnetronzerstäubung beschichtet wird.

11. Verfahren nach einem der vorhergehenden Ansprüche,
dadurch **gekennzeichnet,**
daß zur Erzeugung einer Haftgrenzschicht, insbesondere bei der Beschichtung mit reinen Metallen wie Ti, Cr usw., ein auf das Substrat gerichtetes elektrisches Feld langsam und kontinuierlich durch Verringerung der Biasspannung abgeschwächt wird, und zwar während der Beschichtung mittels Bogenentladungsverdampfung, und daß nach dem Erlöschen des Bogens die Kathodenzerstäubung in Form einer Magnetronzerstäubung kontinuierlich verstärkt wird.

12. Verfahren nach einem der vorhergehenden Ansprüche,
dadurch **gekennzeichnet,**
daß zur Erzeugung der Bogenentladungsverdampfung und der Kathodenzerstäubung ein und dieselbe Kathode verwendet wird.

13. Verfahren nach einem der vorhergehenden Ansprüche,
dadurch **gekennzeichnet,**
daß zur Erzeugung der Bogenentladungsverdampfung, bzw. der Kathodenzerstäubung voneinander verschiedene und getrennt geschaltete Kathoden verwendet werden.

14. Verfahren nach einem der vorhergehenden Ansprüche,
dadurch **gekennzeichnet,**
daß die Magnetkathode als unbalanziertes Magnetron betrieben wird.

15. Verfahren nach einem der vorhergehenden Ansprüche,
dadurch **gekennzeichnet,** daß als unbalanziertes Magnetron ein in der Konfiguration konventionelles Magnetron mit konzentrischer, externer Magnetspule verwendet wird.

16. Verfahren nach einem der vorhergehenden Ansprüche,
dadurch **gekennzeichnet,**
daß während der Beschichtung die Energie der auf dem Substrat auftreffenden Ionen durch entsprechende Wahl des negativen Potentials des Substrats bzw. des Substrathalters gesteuert wird, das im Bereich von $50 \pm 25$ V gewählt wird.

17. Verfahren nach einem der vorhergehenden Ansprüche,

dadurch **gekennzeichnet,**

daß die Biasstromstärke bei der Beschichtung mittels Bogenentladung mit Hilfe der Bogenstromstärke und der Biasvorspannung und bei der Kathodenzerstäubung bzw. Magnetronzerstäubung mit Hilfe der dem Magnetron zugeordneten externen Magnetspule auf einen Wert größer 2 mA/cm$^2$ eingestellt wird.

18. Vorrichtung zur Durchführung des Verfahrens nach einem oder mehreren der Ansprüche 1 bis 17, bei der in einer mit dem entsprechenden Prozeßgas gefüllten Vakuumkammer (1) ein gegenüber der Vakuumkammer elektrisch isolierter Substrathalter (5), eine mit dem Beschichtungsmaterial belegte, gegenüber der Vakuumkammer ebenfalls elektrisch isolierte Kathode (2) und eine für die Bogenentladung erforderliche Anode (3) vorgesehen und die als Elektroden wirkenden Teile (1, 2, 3, 5) durch elektrische Stromkreise miteinander verknüpft sind,

dadurch **gekennzeichnet,**

daß die Kathode (2) wahlweise mit einer Bogenentladungsversorgung (9) oder einer Kathodenzerstäubungsversorgung (12) verbindbar und an derart negative Potentiale schaltbar ist, daß in einem ersten Stromkreis (8) zwischen der Kathode (2) und der Anode (3) eine Bogenentladung oder in einem zweiten Stromkreis (11) eine Kathodenzerstäubungsentladung entsteht.

19. Vorrichtung nach Anspruch 18,

dadurch **gekennzeichnet,**

daß die vom Substrathalter getragenen, Substrate darstellenden Teile durch Anlegen einer negativen Vorspannung aus einer zusätzlichen Stromversorgung (16) in einem Stromkreis (14) wahlweise einem Ätzprozeß, einem Implantationsprozeß nach Anspruch 6 oder 7 oder einem während der Beschichtung stattfindenden Ionenbeschuß unterwerfbar sind.

## Claims

1. A method for the coating of substrates in which the layer to be applied is produced by condensing particles of a plasma generated by means of a gas discharge which are incident on the relevant substrate and in which both an arc discharge vaporization process and also a cathode sputtering process are effected, characterised in that the arc discharge vaporization is only carried out during a first coating phase, and the cathode sputtering is carried out in a second coating phase following this first phase.

2. Method in accordance with claim 1, characterised in that the substrate is first bombarded during arc discharge vaporization with ions and the energy and ion current density are chosen for this such that the substrate surface is cleaned and partially removed by ion etching.

3. Method in accordance with claim 2, characterised in that the bombardment takes place by means of ions of an inert gas or metal ions originating from the cathode or from a mixture of the same.

4. Method in accordance with claim 1, characterised in that for the bombardment of the substrate with ions during the arc discharge vaporization the ion energy and ion flux density are selected such that anchoring of the layer which is to be built up in the substrate material is achieved.

5. Method in accordance with claim 4, characterised in that the bombardment of the substrate takes place with metal ions.

6. Method in accordance with one of the preceding claims, characterised in that the ion bombardment of the substrate is carried out with ion energy and ion current density selected such that ion implantation, in particular an implantation of metal ions, takes place in which the ions penetrate into the substrate up to a depth of a few atomic net planes, and for the anchoring of the layer to be built up, an interdiffusion of atoms into the substrate crystal grid is stimulated as a consequence of local heating which brings about solid solutions of the penetrating atoms in the crystallites, mixed crystallization and with metals for example, also intermetallic compounds.

7. Method in accordance with claim 6, characterised in that titanium ions are used to form the anchoring and in that during the etching process at the surface of the substrate an intermetallic layer is formed directly beneath the surface, for example FeTi in a thickness of 10 to 100 nm, in particular 20 to 40 nm, or with other metals which are difficult to fuse, such as for example zirconium or hafnium.

8. Method in accordance with one of the preceding claims, characterised in that the parameters selected during arc discharge lead to the deposition of a layer, for example of TiN (layer I) and in that this coating is interrupted and is continued by cathodic or magnetron sputtering up to the desired layer thickness (layer II).

9. Method in accordance with claim 8, characterised in that the layer component produced by arc discharge amounts to up to approximately 20% of the total layer thickness formed by layer I and layer II.

10. Method in accordance with one of the preceding claims, characterised in that directly after the formation of the anchoring TiN is directly coated by means of cathode or magnetron sputtering.

11. Method in accordance with one of the preceding claims, characterised in that for the production of a boundary bonding layer, in particular when coating with pure metals such as Ti, Cr etc. an electric field directed onto the substrate is slowly and continuously weakened by reduction of the bias potential, and indeed during the coating by means of arc discharge vaporisation; and in that after the extinguishing of the arc the cathode sputtering is continuously increased in the form of a magnetron sputtering process.

12. Method in accordance with one of the preceding claims, characterised in that one and the same cathode is used for the production of the arc discharge vaporization and of the cathode sputtering.

13. Method in accordance with one of the preceding claims, characterised in that cathodes which are different from one another and separately connected are used to produce the arc discharge vaporization and the cathode sputtering respectively.

14. Method in accordance with one of the preceding claims, characterised in that the magnet cathode is operated as an imbalanced magnetron.

15. Method in accordance with one of the preceding claims, characterised in that a magnetron of conventional configuration with concentric external magnetic coil is used as the imbalanced magnetron.

16. Method in accordance with one of the preceding claims, characterised in that during the coating the energy of the ions impinging onto the substrate is controlled by corresponding choice of the negative potential of the substrate or substrate holder, which is selected in the range of $50 \pm 25$ V.

17. Method in accordance with one of the preceding claims, characterised in that the bias current density is set to a value larger than 2 mA/cm$^2$ with the aid of the arc current density and the bias voltage during coating by means of arc discharge, and with the aid of the magnetic coil associated with the magnetron during cathode sputtering or magnetron sputtering.

18. Apparatus for carrying out the method of one or more of the claims 1 to 17 in which there are provided, in a vacuum chamber (1) filled with the appropriate process gas, a substrate holder (5) which is electrically insulated relative to the vacuum chamber, a cathode (2) which is provided with the coating material and likewise electrically insulated relative to the vacuum chamber, and an anode (3) required for the arc discharge, and in which the parts (1, 2, 3, 5) which act as electrodes are linked together by electric circuits, characterised in that the cathode (2) can be selectively connected to an arc discharge supply (9) or to a cathode sputtering supply (12) and can be connected to such negative potentials that an arc discharge occurs in a first circuit (8) between the cathode (2) and the anode (3), or a cathode sputtering discharge arises in a second circuit (11).

19. Apparatus in accordance with claim 18, characterised in that the parts carried by the substrate holder and representing the substrates can be selectively subjected, by the application of a negative bias voltage from an additional power supply (16) in a circuit (14), to an etching process, to an implantation process in accordance with claim 6 or 7 or to an ion bombardment which takes place during the coating.

## Revendications

1. Procédé d'enduction de substrats, dans lequel la couche à appliquer est constituée par des particules se condensant en frappant le substrat concerné, particules d'un plasma généré au moyen d'une décharge gazeuse, et dans lequel sont entreprise tant une vaporisation par décharge en arc qu'une pulvérisation cathodique, caractérisé en ce que la vaporisation par décharge en arc n'est menée que pendant une première phase d'enduction et la pulvérisation cathodique pendant une deuxième phase suivant cette première phase.

2. Procédé selon la revendication 1, caractérisé en ce que pendant la vaporisation par décharge en arc, le substrat est bombardé par les ions et qu'en outre l'énergie et l'intensité du courant ionique sont choisies, de manière que la surface du substrat soit nettoyée et partiellement emportée par corrosion ionique.

3. procédé selon la revendication 2, caractérisé en ce que le bombardement s'effectue au moyen d'ions de gaz inerte ou d'ions métalliques provenant de la cathode ou d'un mélange de ceux-ci.

4. Procédé selon la revendication 1, caractérisé en ce que lors du bombardement par des ions s'effectuant pendant la vaporisation par décharge en arc, l'énergie ionique et l'intensité du courant ionique sont choisies, de manière qu'un ancrage de la couche à constituer soit réalisé dans la matière du substrat.

5. Procédé selon la revendication 4 caractérisé en ce que le bombardement du substrat s'effectue par des ions métalliques.

6. Procédé selon l'une des revendications précédentes, caractérisé en ce que le bombardement du substrat par des ions est réalisé avec une énergie ionique et une intensité du courant ionique choisies, de manière que se produise une implantation ionique, une implantation d'ions métalliques en particulier, pour laquelle les ions pénètrent dans le substrat, jusqu'à la profondeur de quelques plans d'atomes et , pour l'ancrage de la couche à constituer, par suite d'échauffement local, une interdiffusion d'atomes est activée dans le réseau moléculaire du substrat, laquelle provoque dans les cristallites des solutions solides d'atomes qui pénètrent, une cristallisation mixte et aussi, dans les métaux par exemple, des combinaisons intermétalliques.

7. Procédé selon la revendication 6, caractérisé en ce que pour réaliser l'ancrage, l'on utilise des ions de titane et en ce que, pendant le processus de corrodage à la surface du substrat, il se forme directement sous la surface une couche intermétallique, de FeTi par exemple, sur une épaisseur de 10 à 1000 nm, de 20 à 40 nm notamment, ou comportant d'autres métaux difficilement fusibles comme du zircon ou du hafnium par exemple.

8. Procédé selon l'une des revendications précédentes, caractérisé en ce que les paramètres mis au point pendant la décharge en arc conduisent à un dépôt de couche (couche I), de TiN par exemple, et en ce que cette enduction est interrompue et poursuivie au moyen d'une pulvérisation cathodique ou par magnétron jusqu'à l'épaisseur de couche souhaitée (couche II).

9. Procédé selon la revendication 8, caractérisé en ce que la fraction de couche fabriquée par décharge en arc va jusqu'à environ 20% de l'épaisseur totale de la couche formée par les couches I et II.

10. Procédé selon l'une des revendications précédentes, caractérisé en ce que, immédiatement après la réalisation de l'ancrage, du TiN est enduit directement au moyen d'une pulvérisation cathodique ou par magnétron.

11. Procédé selon l'une des revendications précédentes, caractérisé en ce que pour générer une couche limite adhérente, notamment lors d'enduction comportant des métaux purs comme Ti, Cr, etc. , un champ électrique dirigé sur le substrat est affaibli lentement et en continu par diminution de la tension de polarisation, à savoir pendant l'enduction au moyen d'une vaporisation par décharge en arc et en ce que, l'arc éteint, la vaporisation cathodique est renforcée en continu sous forme d'une vaporisation par magnétron.

12. Procédé selon l'une des revendications précédentes, caractérisé en ce que l'on utilise une seule et même cathode pour générer la vaporisation par décharge en arc et la pulvérisation cathodique.

13. Procédé selon l'une des revendications précédentes, caractérisé en ce que l'on utilise des cathodes différentes les unes des autres et montées séparément pour générer la vaporisation par décharge en arc et la pulvérisation cathodique.

14. Procédé selon l'une des revendication précédentes, caractérisé en ce que la cathode magnétique est actionnée comme un magnétron déséquilibré.

15. Procédé selon l'une des revendications précédentes, caractérisé en ce que comme magnétron déséquilibré, l'on utilise un magnétron de configuration usuelle comportant une bobine magnétique concentrique externe.

16. Procédé selon l'une des revendications précédentes, caractérisé en ce que pendant l'enduction, l'énergie des ions frappant le substrat est commandée par le choix convenable du potentiel négatif du substrat ou de son support potentiel choisi dans la zone de 50 $\pm$ 25 V.

17. Procédé selon l'une des revendications précédentes, caractérisé en ce que l'intensité du courant de polarisation est réglée sur une valeur supérieure à 2mA/cm$^2$ et ce à l'aide de l'intensité du courant d'arc et de la tension de polarisation lors de l'enduction par décharge en arc et à l'aide de la bobine magnétique externe associée au magnétron lors de la pulvérisation cathodique ou de la pulvérisation par magnétron.

18. Dispositif servant à conduire le procédé selon l'une ou plusieurs des revendications 1 à 17, dispositif dans lequel, dans une chambre à vide (1) remplie du gaz correspondant au processus, sont prévus un support de substrat (5) isolé électriquement par rapport à la chambre à vide, une cathode (2) recouverte du matériau d'enduction, isolée électriquement également par rapport à la chambre à vide, et une anode (3) nécessaire pour la décharge en arc, les éléments (1,2,3,5) agissant comme des électrodes, étant connectés entre eux au moyen de circuits électriques, caractérisé en ce que la cathode (2) est reliable au choix à une alimentation de décharge en arc (9) ou à une alimentation de pulvérisation cathodique (12) et est connectable à des potentiels négatifs, de manière qu'il en résulte dans un premier circuit (8) une décharge en arc entre la cathode (2) et l'anode (3) et, dans un deuxième circuit (11) une décharge de pulvérisation cathodique.

19. Dispositif selon la revendication 18, caractérisé en ce que les parties représentatives des substrats portés par les supports de substrat sont, par application d'une tension négative à partir d'une alimentation de courant supplémentaire (16) dans un circuit (14), soumises au choix à un processus de corrodage, à un processus d'implantation selon la revendication 6 ou 7 ou à un bombardement ionique ayant lieu pendant l'enduction.

# Fig.1

Typische Maxwell-Energieverteilung

N = Anzahl der Atome oder Ionen

Für Kristallwachstum zu geringe Energie

optimale Energie

Defekte
Dislokationen

0 5 40        80eV        200eV                                              E

Faser - und Stengelwachstum        Zu Zerstörungen führende Energie

14

# Fig. 2

Verdampfung mittels Bogenentladung

Kathodenzerstäubung

Fig.3

## Fig.4

## Fig.5

# Fig.6

Mittels Spule erzeugtes
unbalanziertes Magnetron

EP 0 439 561 B1

# Fig.7

Beispiel TiN

| | | |
|---|---|---|
| (1.....10µm) | TiN | (SPUTTERING) |
| (0,05.....0,2µm) | TiN | (ARC DISCHARGE) |
| (0,05....0,2µm) | TiFe | VERANKERUNGSZONE |
| | Stahl (Fe) | |

SUBSTRAT

# Fig.8

V                     BIASPOTENTIAL

t ——→

I                     BIASSTROM

t ——→

I                     BOGENENTLADUNGSSTROM

t ——→

V                     KATHODENPOTENTIAL

t ——→

I                     KATHODENZERSTÄUBUNGSSTROM

t ——→

Spullercleaning und       Magnetstromverstärkung
Verankerung

Schnellbildung mit Bogenentladungsverdampfung

20

# Fig.9

Beispiel TiN

(1.....10µm)                TiN                    (SPUTTERING)

(0,05.....0,2µm)            TiFe                   (VERANKERUNGSZONE)

Stahl (Fe)

SUBSTRAT

# Fig.10

V           BIASPOTENTIAL

t

I           BIASSTROM

t

I           BOGENENTLADUNGSSTROM

t

V           KATHODENPOTENTIAL

t

I           KATHODENZERSTÄUBUNGSSTROM

t

Sputtercleaning und Verankerung        Magnetron-Verstärkung